# EUROPÄISCHE PATENTANMELDUNG

(11) **EP 2 101 354 A2**
(43) Veröffentlichungstag der Anmeldung: **16.09.2009**
(21) Anmeldenummer: 09003447.1
(22) Anmeldetag: 10.03.2009
(51) Int. Cl.: H01L 27/142, H01L 31/18, B23K 26/36, B23K 26/40, B23K 26/04

(54) **Verfahren und Vorrichtung zur Bildung der Trennlinien eines photovoltaischen Moduls mit serienverschalteten Zellen**

(30) Priorität: 13.03.2008 DE 102008014263
(71) Anmelder: SCHOTT Solar AG, 55122 Mainz (DE)
(72) Erfinder: Psyk, Walter, 81371 München (DE)
(74) Vertreter: Haft, von Puttkamer, Berngruber

(57) **Zusammenfassung**

Zur Bildung der Trennlinien (5, 6, 7), die bei der Herstellung eines photovoltaischen Moduls mit serienverschalteten Zellen (C1, C2, ...) in den auf einem transparenten Substrat (1) abgeschiedenen Funktionsschichten (2, 3, 4) erzeugt werden, werden Laserscanner (8) verwendet, deren Laserstrahl (14) in dem von ihm abgetasteten Feld (17) mehrere nebeneinander angeordnete Trennlinienabschnitte (18) in der Funktionsschicht (2, 3, 4) erzeugt. Die Laserscanner (8) werden dann relativ zu dem beschichteten Substrat (1) in Richtung (Y) der Trennlinien (5, 6, 7) um einen Abstand bewegt, der höchstens der Länge (L) des abgetasteten Feldes (17) entspricht, um so durch miteinander fluchtende Trennlinienabschnitte (18) durchgehende Trennlinien (5, 6, 7) zu bilden.

## Beschreibung

Die Erfindung bezieht sich auf ein Verfahren zur Bildung der Trennlinien, die bei der Herstellung eines photovoltaischen Moduls mit serienverschalteten Zellen in den Funktionsschichten auf dem transparenten Substrat gebildet werden, nach dem Oberbegriff des Anspruchs 1. Sie hat auch eine Vorrichtung zur Durchführung des Verfahrens zum Gegenstand.

Bei der Herstellung eines photovoltaischen Moduls werden auf dem elektrisch isolierenden transparenten Substrat, in der Regel eine Glasscheibe, ganzflächig die transparente Frontelektrodenschicht, die Halbleiterschicht und die Rückelektrodenschicht abgeschieden, die die Funktionsschichten des Moduls bilden.

Die einzelnen monolithischen Schichten werden z. B. mit einem Laser durch Trennlinien so strukturiert, dass sie serienverschaltete streifenförmige Zellen bilden. Der erzeugte Strom wird dabei durch Kontaktierung der beiden äußerten Zellen abgenommen. Somit können Dünnschichtmodule mit unterschiedlichen Spannungen, z. B. für 12V-Verbraucher realisiert werden.

Zur Strukturierung wird das beschichtete Substrat typischerweise auf einem in X- und Y-Richtung verfahrbaren Tisch angeordnet. Statt dessen kann ein verfahrbares Portal mit dem Laser oder ein in Y-Richtung verfahrbarer Tisch und ein stationäres Portal mit einem in X-Richtung verfahrbaren Laser verwendet werden (sogenanntes "Split-Axis-System"), das nachstehend stellvertretend für die anderen Systeme als Stand der Technik beschrieben wird.

Bei dem Split-Axis-System wird mindestens ein Laserstrahl mit zu mindestens einer entlang einem Portal in X-Richtung, also senkrecht zu den zu bildenden Trennlinien bewegbaren Fokussieroptik in die dünnen Funktionsschichten fokussiert. Durch Bewegung des beschichteten Substrats unter der Fokussieroptik in Y-Richtung, also in Richtung der zu bildenden Trennlinie wird dann die Trennlinie in der Funktionsschicht durch den fokussierten Laserstrahl gebildet.

Die Trennlinien verringern die photovoltaisch aktive Fläche um deren Flächeninhalt und tragen somit nicht zur Umsetzung des Sonnenlichtes in elektrische Energie bei. Es ist deshalb notwendig, die Trennlinien schmal zu gestalten, wobei sie typischerweise eine Breite von 50 µm aufweisen. Auch sollen die Abstände der Trennlinien, die zu Verlustflächen gezählt werden müssen, möglichst klein sein, um die gesamte Verlustfläche durch die integrierte Serienverschaltung gering zu halten. Dadurch werden hohe Anforderungen an die Genauigkeit bzw. Toleranzen des Strukturierungssystems gestellt. Wenn unter der Prämisse, dass zwei benachbarte Trennlinien 100 µm auseinander liegen und diese Linien typischerweise 50 µm breit sind, sich maximal berühren, aber nicht überschneiden dürfen, ergibt sich eine Toleranz bzw. Genauigkeit von +/- 25 µm für das Strukturierungssystem. Wenn ein Modul beispielsweise 160 in Serie verschaltete Zellen aufweist, sind pro Funktionsschicht 160 Trennlinien notwendig. Bei einem Modul mit einer Größe von beispielsweise ca. 1,4 m² (z. B. 1100 mm x 1300 mm) werden somit beispielsweise bei vier Fokussieroptiken am Portal im Idealfall 40 Bewegungen notwendig.

Bei einer Jahreskapazität von beispielsweise 90000 beschichteten Substraten pro Strukturierungssystem ergeben sich dann 3,6 Millionen Bewegungen pro Strukturierungssystem, die bei schnellster Bewegungsgeschwindigkeit, typischerweise 1200 mm/s durchgeführt werden. Bei einem solchen oszillierenden Bewegungssystem müssen noch die Beschleunigungszeiten und die Zustellbewegungen der Fokussieroptiken zu der nächsten Trennlinie berücksichtigt werden.

Die Konstruktionen für diese Strukturierungssysteme sind daher aufwändig, schwer und kostenintensiv. Bei beispielsweise 160 Trennlinien auf einem 1300 mm langen Substrat, vier Fokussieroptiken, einer Bewegungsgeschwindigkeit von 1200 mm/s, einer Beschleunigung von 2 g und einer Zustellzeit in X-Richtung von 0,3 s ergibt sich eine Bearbeitungszeit für das Modul von ca. 60 Sekunden. Hinzu kommen für das Be- und Entladen, die Fixierung und die beispielsweise durch Bildverarbeitung erfolgte Lageerkennung des beschichteten Substrats nochmals typischerweise ca. 30 Sekunden pro Laser-Bearbeitungsschritt.

Um den Durchsatz mit der gleichen Genauigkeit bzw. Toleranz des Strukturierungssystems zu erhöhen, ist es zwar möglich, neben der Erhöhung der Zahl der Fokussieroptiken auch die Bewegungsgeschwindigkeit des Strukturierungssystems zu erhöhen, jedoch werden dann die Konstruktionen noch erheblich komplexer, größer, schwerer und kostspieliger.

Für die industrielle Herstellung eines photovoltaischen Moduls werden mehrere kostspielige Anlagen benötigt. Die Anlage zur Halbleiterbeschichtung ist dabei meist mit den höchsten Investitionskosten verbunden. Daneben stellen die oben genannten Laseranlagen wichtige Kostenfaktoren dar.

Die Kapazität der Halbleiterbeschichtungsanlage und die Kapazität der Laseranlagen sind meist unterschiedlich. Als kostspieligste Anlage wird dabei die Halbleiterbeschichtungsanlage im allgemeinen zu 100 % ausgelastet.

Wenn mit der Halbleiterbeschichtungsanlage beispielsweise maximal eine Beschichtung von 210000 Modulen pro Jahr durchgeführt wird und jede Strukturierungsanlage pro Funktionsschicht (Frontelektrodenschicht, Halbleiterschicht, Rückelektrodenschicht) für 90000 Module pro Jahr ausgelegt ist, hat dies zur Folge, dass insgesamt neun kostspielige Laseranlagen angeschafft werden müssen. Die Zahl der Laseranlagen führt daher bei der industriellen Herstellung von photovoltaischen Modulen zu einem erheblichen Kostenproblem.

Aufgabe der Erfindung ist es daher, ein Verfahren und eine Vorrichtung bereitzustellen, mit dem bzw. der die Kosten zur Bildung der Trennlinien in den Funktionsschichten bei der industriellen Herstellung photovoltaischer Module deutlich herabgesetzt werden können.

Dies wird erfindungsgemäß mit dem im Anspruch 1 gekennzeichneten Verfahren erreicht. In den Unteransprüchen 2 bis 5 sind vorteilhafte Ausgestaltungen des erfindungsgemäßen Verfahrens wiedergegeben. Der Anspruch 6 hat eine bevorzugte Vorrichtung zur Durchführung des erfindungsgemäßen Verfahrens zum Gegenstand, welche durch die Maßnahmen der Ansprüche 7 bis 20 in vorteilhafter Weise weiter ausgestaltet wird.

Nach der Erfindung wird als Laser wenigstens ein Laserscanner verwendet, dessen Laserstrahl in dem von ihm abgetasteten Feld mehrere nebeneinander angeordnete Trennlinienabschnitte in der Funktionsschicht erzeugt, wobei der Laserscanner nach Abtasten des Feldes relativ zu dem beschichteten Substrat bewegt wird, um durch miteinander fluchtende Trennlinienabschnitte sich über die gesamte Länge des Moduls erstreckende, durchgehende Trennlinien zu bilden.

Dabei erfolgt die Relativbewegung von Laserscanner und beschichtetem Substrat vorzugsweise in Richtung der Trennlinien um einen Abstand, der höchstens der Länge des abgetasteten Feldes entspricht. Die Richtung der Relativbewegung kann dabei die Y- oder X-Richtung sein.

Die transparente Frontelektrodenschicht kann aus einem elektrisch leitfähigem Metalloxid, beispielsweise Zinnoxid (SnO₂), Zinkoxid (ZnO) oder einem anderen Material bestehen. Die Halbleiterschicht kann aus Silizium, beispielsweise amorphen, nano-, mikro- oder polykristallinem Silizium bestehen, aber auch aus anderen Halbleitern, beispielsweise Cadmium-Tellur oder Kupfer-Indium-Gallium-Selenid (CIGS). Die Rückelektrodenschicht ist vorzugsweise eine Metallschicht, beispielsweise aus Aluminium, Kupfer, Silber oder dergleichen. Alternativ kann auch ein nicht transparentes Substrat verwendet werden.

Das Substrat kann durch eine Glasplatte oder ein anderes transparentes, elektrisch isolierendes Material gebildet werden.

Der wenigstens eine Laserscanner ist an einer Halterung angeordnet, die durch eine Einrichtung relativ gegenüber einer Aufnahme für das beschichtete Substrat bewegbar ist.

Mit dem Laserstrahl des Laserscanners wird ein Feld oder eine Fokussierfläche mit einer Größe von vorzugsweise mindestens 100 cm² auf der Funktionsschicht abgetastet, die mit der Trennlinie versehen werden soll. Dazu ist der Laserscanner mit wenigstens einem Spiegel versehen, der den Laserstrahl auf die Funktionsschicht lenkt.

Um eine Zeile, also in dem Feld einen Abschnitt der Trennlinie zu erzeugen, wird der Spiegel vorzugsweise mit einem Galvanometerantrieb gedreht. Nach dem Erzeugen der einzelnen Zeile bzw. des Trennlinienabschnitts in dem Feld, muss der Laserstrahl auf die nächste Zeile ausgerichtet werden, um den nächsten parallelen Trennlinienabschnitt in diesem Feld zu erzeugen.

Das heißt, der Spiegel muss dann zunächst in X-Richtung, also in eine zur Trennlinienrichtung quer bzw. senkrecht verlaufende Richtung ausgelenkt werden, und zwar um einen Abstand, der dem Abstand zweier benachbarter Trennlinien entspricht, bevor der nächste Trennlinienabschnitt in diesem Feld erzeugt wird.

Vorzugsweise weist der Laserscanner dazu jeweils zwei orthogonal zueinander bewegbare Spiegel auf, die den Laserstrahl reflektieren und vorzugsweise von einem Galvanometerantrieb angetrieben werden.

Auf diese Weise können mit der Scannersoftware eine Vielzahl parallel nebeneinander angeordnete Trennlinienabschnitte in dem betreffenden Feld erzeugt werden.

Das heißt, der wenigstens eine Laserscanner kann in X-Richtung relativ zu dem beschichteten Substrat um einen Abstand bewegt werden, der höchstens der Breite des abgetasteten Feldes entspricht, bis das beschichtete Substrat über seine gesamte Breite mit den nebeneinander angeordneten Trennlinienabschnitten versehen ist. Anschließend werden Laserscanner und Substrat um höchstens eine Feldlänge relativ zueinander bewegt, um die nächste sich in X-Richtung erstreckende Reihe von Trennlinienabschnitten zu bilden, die mit den zuvor gebildeten Trennabschnitten verbunden sind, usw.

Zwar ist es möglich, den wenigstens einen Laserscanner an der Halterung, also beispielsweise an einem sich über das beschichtete Substrat erstreckenden Portal in X-Richtung um einen der Breite des Feldes entsprechenden Abstand zu verschieben, um die Trennlinienabschnitte dem in X-Richtung dazu anschließenden Feld zu bilden.

Es ist jedoch auch möglich, an einem solchen Portal mehrere Laserscanner nebeneinander anzubringen, sodass sich eine quer über das Substrat erstreckende Reihe von Laserscanner ergibt, also sich ein Feld an das andere reiht, wobei alle Felder eine Reihe mit den jeweiligen Laserscannern gleichzeitig gelasert werden.

Auf diese Weise können mit einer Relativbewegung des Substrats gegenüber der Laserscanner-Reihe über die gesamte Breite des Substrats sich in Y-Richtung erstreckenden die Trennlinienabschnitte in der Funktionsschicht erzeugt werden. Im nächsten Schritt werden das Substrat und die Laserscanner-Reihe gegenüber einander um maximal eine Feldlänge bewegt, um so die Trennlinienabschnitte schrittweise zu verlängern, bis die einzelnen miteinander fluchtenden Trennlinienabschnitte die durchgehenden Trennlinien in dieser Funktionsschicht bilden.

Wesentlich ist dabei, dass, wenn mehrere nebeneinander angeordnete Laserscanner verwendet werden, die Breite des Feldes das von dem einen Laserscanner abgetastet wird, in X-Richtung so bemessen ist, dass es von dem Feld, das von dem benachbarten Laserscanner abgetastet wird, höchstens um einen Trennlinienabstand entfernt ist. Vorzugsweise erfolgt jedoch eine Überlappung der Felder.

Insbesondere ist eine Überlappung des Feldes dann notwendig, wenn die Trennlinien in den Funktionsschichten nicht in Y-Richtung, sondern in X-Richtung des beschichteten Substrats verlaufen, also bei einem rechteckigen Substrat nicht in Längsrichtung, sondern quer. Dazu werden mit den Laserscannern an dem Portal sich über die gesamte Breite des beschichteten Substrats bzw. in X-Richtung erstreckende durchgehenden Trennlinien gebildet. Dann erfolgt eine Relativbewegung der Laserscanner und des Substrats in Y-Richtung um einen Abstand, der höchstens der Breite der Felder der Laserscanner, gegebenenfalls plus einen Trennlinienabstand entspricht, worauf mit den Laserscannern erneut sich über die gesamte Breite des beschichteten Substrats bzw. in X-Richtung erstreckende durchgehende Trennlinien gebildet werden. Dieser Vorgang wird so oft wiederholt, bis das beschichteten Substrat über seine gesamte Länge, also auch in Y-Richtung mit den Trennlinien versehen ist.

Mit einem solchen Laserscanner können die Trennlinienabschnitte mit einer hohen Geschwindigkeit von vorzugsweise mindestens 1 m/s, insbesondere mindestens 5 m/s erzeugt werden. Die Felder, die von dem Laserstrahl zur Erzeugung der Trennlinienabschnitte abgetastet werden, weisen vorzugsweise jeweils eine Fläche von mindestens 100 x 100 mm² auf.

Wenn mehrere Laserscanner vorgesehen sind, können sie so angeordnet sind, dass die von ihnen abgetasteten Flächen in X-Richtung aneinander anschließen und miteinander fluchten. Es ist jedoch auch möglich, die nebeneinander angeordneten Laserscanner an der Halterung in Richtung der Trennlinien, also Y-Richtung derart versetzt anzuordnen, dass ein in die eine Richtung versetzter Laserscanner auf Lücke zu zwei in der anderen Richtung versetzten Laserscannern ausgerichtet ist.

Die erfindungsgemäße Vorrichtung kann sowohl als Gantry-System wie als Split-Axis-System ausgebildet sein.

Das heißt, die Halterung für den wenigstens einen Laserscanner kann durch ein in Y-Richtung verfahrbares Portal gebildet werden, wie bei dem Gantry-System. Statt dessen kann, wie bei dem Split-Axis-System die Aufnahme für das beschichtete Substrat durch einen in Y-Richtung verfahrbaren Tisch gebildet werden, während die Halterung aus einem stationären Portal besteht, an dem der bzw. die Laserscanner in X-Richtung verfahrbar angeordnet sind.

Es ist nicht notwendig, dass jeder Laserscanner eine eigene Laserquelle besitzt. Vielmehr kann der Laserstrahl der Laserquelle in Teilstrahlen geteilt werden, wobei jeder Teilstrahl von dem wenigstens einen Spiegel des Laserscanners reflektiert wird, um mit diesem Laserscanner das ihm zugeordnete Feld abzutasten. Das heißt, bei einer leistungsstarken Laserquelle, kann der Laserstrahl geteilt werden, um dann mit einem Teilstrahl die Trennlinienabschnitte des jeweiligen Feldes zu erzeugen.

Vorzugsweise wird ein Neodym dotierter Festkörperlaser, insbesondere ein Neodym dotierter Yttrium-Vanadat-Laser (Nd:YVO₄-Laser) oder Neodym dotierter Yttrium-Aluminium-Granat-Laser (Nd:YAG-Laser) mit einer Grundwellenlänge von 1064 nm oder der zweiten harmonischen Wellenlänge von 532 nm oder der dritten harmonischen Wellenlänge von 335 nm eingesetzt.

Das Be- und Entladen des Substrats kann von derselben Seite der erfindungsgemäßen Funktionsschichtstrukturierungsvorrichtung erfolgen. Vorzugsweise ist jedoch eine Einrichtung zum Transport des von der Aufnahme aufgenommenen beschichteten Substrats von einer Beladestation auf einer Seite der erfindungsgemäßen Funktionsschichtstrukturierungsvorrichtung oder Bearbeitungsstation zu einer Entladestation auf der anderen Seite der Vorrichtung vorgesehen.

Die Transporteinrichtung kann eine Endlosfördereinrichtung sein, die mit einer Aufnahme mit einer Fixiereinrichtung, beispielsweise einer Klemmeinrichtung für das beschichtete Substrat versehen ist, sie kann jedoch auch durch eine andere Einrichtung gebildet sein, mit der die Aufnahme, an der das beschichtete Substrat z. B. mit einer Klemmeinrichtung fixiert ist, von der Beladestation über die Strukturierungsvorrichtung zu der Entladestation bewegt wird.

Das beschichtete Substrat kann beispielsweise mit einer Mehrachsenroboter so in die Beladestation geladen.werden, dass nach Fixierung des Substrats der Laserstrahl beim Strukturierungsprozess direkt in die Funktionsschicht fokussiert wird, oder wenn das Substrat um 180° gekippt beladen und fixiert wird, der Laserstrahl durch das transparente Substrat hindurch in die dünne Funktionsschicht fokussiert wird. Vorzugsweise wird der Strukturierungsprozess mit einem hochkant stehenden Substrat durchgeführt, durch das der Laserstrahl hindurch in die Funktionsschicht fokussiert wird.

Nach der Fixierung in der Beladestation wird das Substrat durch die Transporteinrichtung in die Strukturierungsvorrichtung oder Bearbeitungsstation transportiert und fixiert.

Zur Lageerkennung und Justierung des beschichteten Substrats in der Beladestation können beispielsweise zwei Kameras vorgesehen sein, die mit einer Bildverarbeitungssoftware die Position des Substrats ermitteln. Eine in der Strukturierungsvorrichtung integrierte Mechanik kann dann durch Drehung des Substrats dieses zu dem Koordinatensystem der Software parallelisieren. Der Offset in X- und Y-Richtung wird beispielsweise in die Software gerechnet und das Koordinatensystem der Software entsprechend in X und Y verschoben. Auch kann die Parallelisierung des Substrats alternativ zur mechanischen Drehung des Substrats durch eine Drehung des Koordinatensystems der Software erfolgen. Damit ist das Substrat in der Strukturierungsvorrichtung oder Bearbeitungsstation justiert.

Nachstehend ist die Erfindung anhand der beigefügten Zeichnung beispielhaft näher erläutert. Darin zeigen jeweils schematisch:
Figur 1 einen Schnitt durch einen Teil eines mit serienverschalteten Zellen versehenen Substrats eines photovoltaischen Moduls, wobei die Funktionsschichten stark vergrößert wiedergegeben sind;
Figur 2 eine perspektivische Ansicht eines Laserscanners und eines Teils des beschichteten Substrats;
Figur 3 und 4 die Vorderansicht auf eine Anlage nach dem Gantry- bzw. Split-Axis-System zur Erzeugung der Trennlinien in einer Funktionsschicht des Substrats;
Figur 5 die Vorderansicht auf ein Portal mit versetzten Laserscannern;
Figur 6 einen Querschnitt entlang der Linie V-V in Figur 3;
Figur 7 eine Draufsicht auf zwei in Y-Richtung nebeneinander angeordnete Felder; und
Figur 8 eine vergrößerte Wiedergabe des Bereiches A in Figur 7.

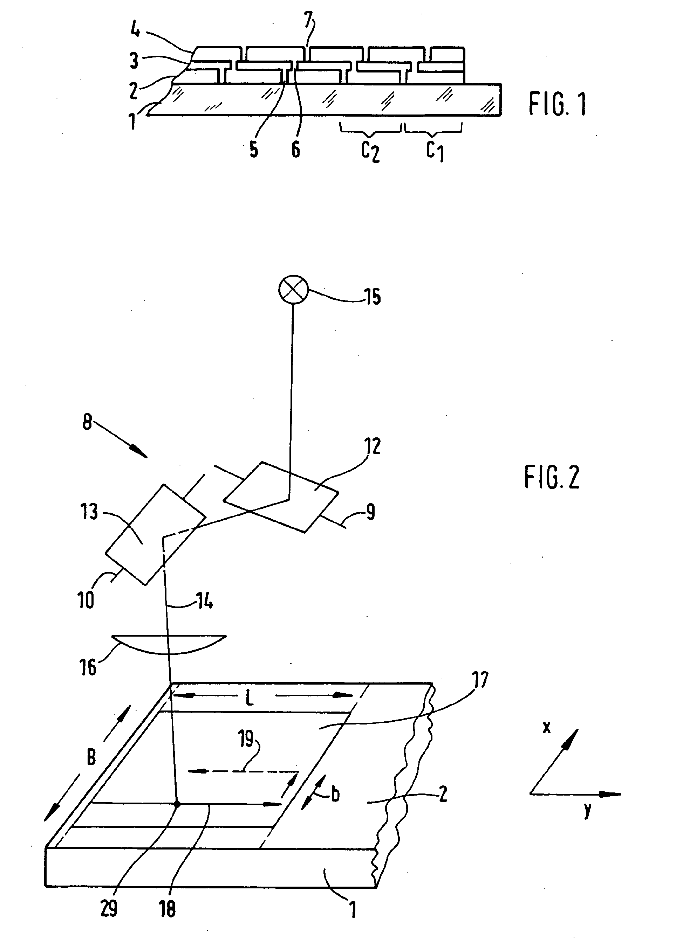

Gemäß Figur 1 weist ein transparentes Substrat 1, beispielsweise eine Glasscheibe, eine transparente Frontelektrodenschicht 2, eine Halbleiterschicht 3 und eine Rückelektrodenschicht 4 auf.

Die Funktionsschichten 2, 3 und 4 sind mit Trennlinien 5, 6, 7 versehen, um serienverschaltete streifenförmige Zellen C1, C2, ... zu bilden.

Die Trennlinien 5, 6, 7 werden mit Laserscannern 8 erzeugt.

Gemäß Figur 2 weist der Laserscanner 8 zwei um die orthogonalan Achsen 9, 10 drehbare Spiegel 12, 13 auf, über die der Laserstrahl 14 von der Laserquelle 15 zu einer Fokussieroptik 16 reflektiert wird, mit der der Laserstrahl 14 auf der Funktionsschicht, beispielsweise der Frontelektrodenschicht 2 fokussiert wird.

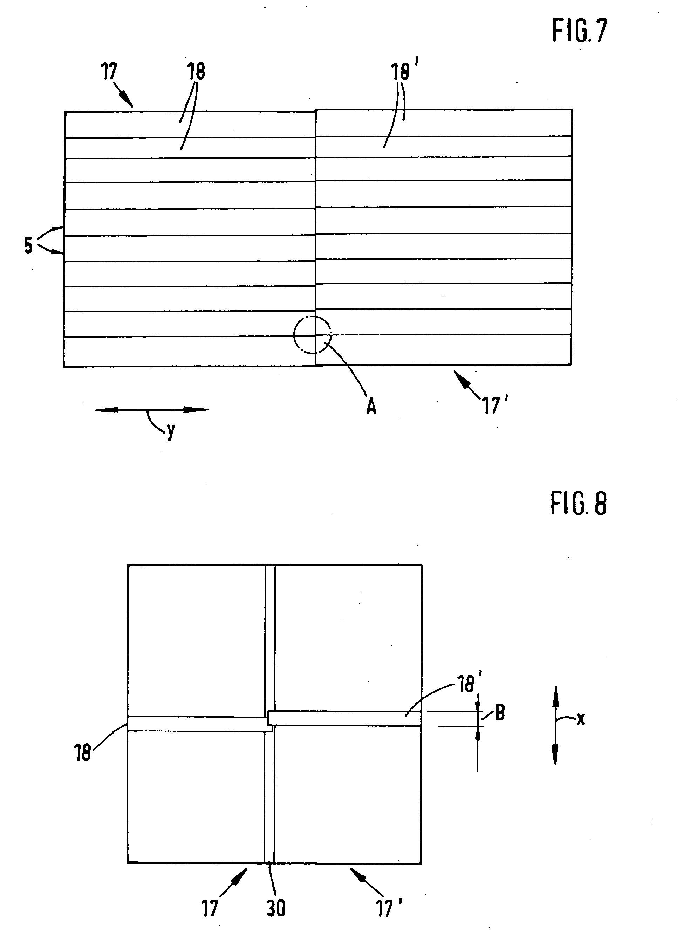

Wie in Figur 2 dargestellt, wird mit dem Laserstrahl 14 jedes Laserscanners 8 eine Fokussierfläche oder Feld 17, z. B. mit einer Länge L von 150 mm und einer Breite B von 150 mm auf der Funktionsschicht 2 abgetastet, die mit den in Y-Richtung verlaufenden Trennlinien 5 versehen werden soll (Figur 7).

Dazu ist der Laserscanner 8 mit den beiden durch jeweils einen nicht dargestellten Galvanometerantrieb betätigbare Spiegel 12, 13 versehen.

Laserscanner mit einem Scankopf, wie in Figur 2 mit "8" dargestellt, sind bekannt. Auch wird dabei zum Drehen der Spiegel meist ein Galvanometerantrieb (kurz: Galvo) verwendet.

Um in dem Feld 17 eine Zeile, d. h. einen Abschnitt 18 (Figur 2) einer Trennlinien 5 zu erzeugen, wird der Spiegel 12 gedreht und dadurch der Laserstrahl 14 in Y-Richtung abgelenkt.

Nach dem Erzeugen des in Figur 2 sich über die gesamte Länge L des Feldes 17 erstreckenden Trennlinienabschnitts 18 in dem Feld 17 muss der Laserstrahl 14 auf die nächste in Figur 2 gestrichelt dargestellte Zeile 19 gelenkt werden, um den nächsten parallelen Trennlinienabschnitt in dem Feld 17 zu erzeugen.

Dazu wird zunächst der Spiegel 13 gedreht und damit der Laserstrahl 14 in die zu der Y-Richtung senkrechte X-Richtung um den Abstand b gelenkt, der dem Abstand zweier benachbarter Trennlinien 5 in der Funktionsschicht 2 entspricht. Alsdann wird wieder der Spiegel 12 betätigt, wodurch in der Zeile 19 der nächste sich über die gesamte Länge des Feldes 18 erstreckende Trennlinienabschnitt gebildet wird. Dieser Vorgang wird so oft wiederholt, bis das Feld 17 über seine gesamte Breite B mit Trennlinienabschnitten 18 versehen ist.

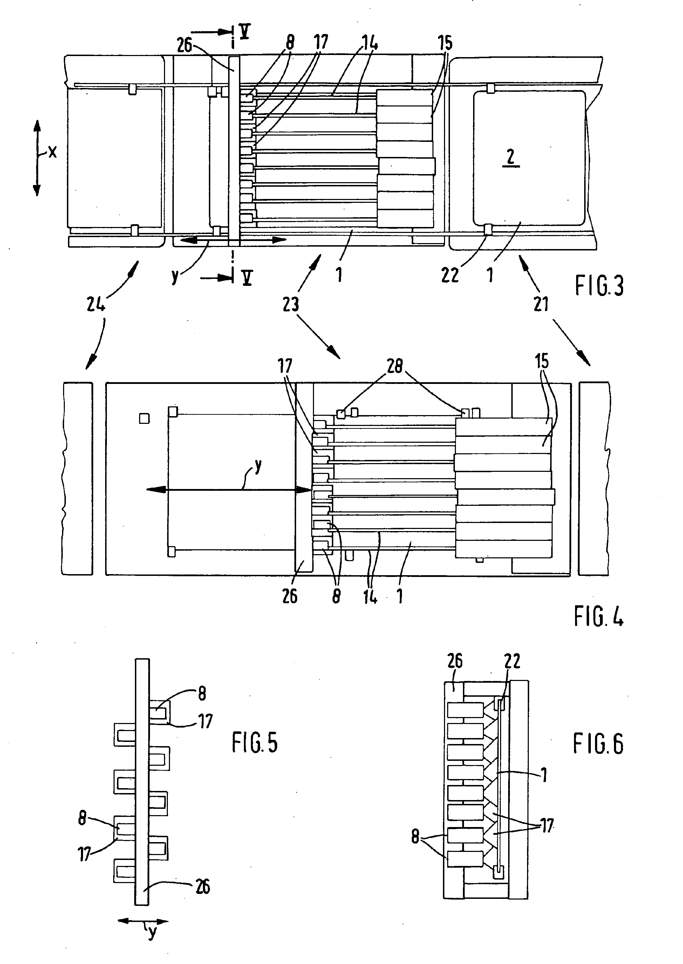

Gemäß Figur 3 und 4 weist eine Anlage zur Bildung der Trennlinien 5, 6, 7 eine Beladestation 21 auf, an der das beispielsweise mit der Frontelektrodenschicht 2 beschichtete Substrat 1 mit einer durch eine Klemmeinrichtung gebildeten Aufnahme 22 hochkant, gegebenenfalls auch schräg, fixiert wird.

Von der Beladestation 21 wird das Substrat 1 zu der Bearbeitungsstation 23 in Y-Richtung bewegt, an der die Trennlinien 5 in der Schicht 2 erzeugt werden, und von dort zu der Entladestation 24 auf der anderen Seite der Bearbeitungsstation 23.

Die Bearbeitungsstation 23 weist dabei acht Laserscanner 8 mit jeweils einer Laserquelle 15 auf. Die acht Laserscanner 8 sind an einer als Portal ausgebildeten Halterung 26 angeordnet und erstrecken sich damit in einer Reihe quer, d. h. in X-Richtung über das zu bearbeitende Substrat 1, dessen Schicht 2 mit den Trennlinien 5 versehen werden soll.

Jeder Laserscanner 8 gemäß Figur 3 und 4 ist im Wesentlichen so aufgebaut, wie im Zusammenhang mit Figur 2 beschrieben. Das heißt, alle acht Laserscanner 8 versehen gleichzeitig das darunter liegende Feld 17 mit sich über die gesamte Länge L jedes Feldes 17 erstreckenden Trennlinienabschnitten 18. Die einzelnen Felder 17 unter den Laserscannern 8 schließen dabei in Y-Richtung aneinander an. Damit wird das Substrat 1 über seine gesamte Breite mit in einer Reihe angeordneten parallelen Trennlinienabschnitten 18 versehen, die eine den Feldern 17 entsprechende Länge L aufweisen.

Im nächsten Schritt müssen die Laserscanner 8 relativ zu dem Substrat 1 in Y-Richtung bewegt werden und zwar um einen Abstand, der höchstens der Länge L der Felder 17 entspricht.

Alsdann wird mit den Laserscannern 8 eine zweite sich über die gesamte Breite des Substrats 1 erstreckende Reihe von parallelen Trennlinienabschnitten 18 gebildet. Dieser Vorgang wird solange wiederholt, bis die Trennlinienabschnitte 18 der einzelnen Reihen sich in Y-Richtung über die gesamte Länge des Subtrats 1 erstreckende durchgehende Trennlinien 5 in der Schicht 2 bilden.

Bemerkt sei, dass der Abstand, um den die Laserscanner 8 in Y-Richtung bei jedem Schritt bewegt werden, etwas geringer ist als die Länge der Felder 17, um eine Überlappung der Felder 17 in der Y-Richtung zu erzielen. Damit durchgehende Trennlinien gebildet werden, ist es ferner erforderlich, dass die einzelnen Trennlinienabschnitte 18 jeder Trennlinie 5 miteinander fluchten.

Dies ist in Figur 7 und 8 näher dargestellt. Dabei zeigt Figur 7 zwei in Y-Richtung aneinander anschließende Felder 17, 17' mit den Trennlinien 5, die durch die Trennlinienabschnitte 18, 18' benachbarter Felder 17, 17' gebildet werden.

Wenn die Breite B' der Trennlinien z. B. 50 µm beträgt, muss eine Genauigkeit von ± 25 µm in X-Richtung eingehalten werden und durch eine Überlappung 30 werden durchgehende Trennlinien 18, 18' gebildet.

Während bei dem in Figur 3 dargestellten Gantry-System zur Relativbewegung der Laserscanner 8 und des Substrats 1 die als Portal ausgebildete Halterung 26 in Y-Richtung bewegt wird, wird bei dem in Figur 4 dargestellten Split-Axis-System bei stationärer Halterung 26 das Substrat 1 in Y-Richtung bewegt.

Wie in Figur 5 dargestellt, können die Laserscanner 8 an der Halterung 26 auch in Y-Richtung versetzt angeordnet sein und zwar derart, dass ein in der einen Y-Richtung, also z. B. nach links versetzter Laserscanner 8 auf Lücke zu zwei in der anderen Y-Richtung, also nach rechts versetzten Laserscannern 8 ausgerichtet ist.

Wie aus Figur 6 hervorgeht, muss die zu bearbeitende Schicht, beispielsweise die Frontelektrodenschicht 2 exakt in der Fokussierebene der Laserscanner 8 angeordnet sein. Dazu sind an der Bearbeitungsstation 23 zwei Kameras 28 angeordnet, sodass durch Bildverarbeitung eine Lageerkennung und damit Justierung des Substrats 1 in der Bearbeitungsstation 23 möglich ist.

Bei dem vorstehend beschriebenen Ausführungsbeispiel hat die X-Achse des Gantry-Systems gemäß Figur 3 acht nebeneinander angeordnete Laserscanner 8, wobei sich benachbarte Fokussierfelder 17 vorzugsweise um wenige Millimeter überlappen. Für ein Substrat 1 mit z. B. 1300 mm Länge in Y-Richtung werden bei einer Fläche des Fokussierfeldes von 150 x 150 mm² pro Laserscanner 8 neun Schritte für die Strukturierung des beispielsweise 1,4 m² großen Substrats 1 benötigt.

Dabei können in einem Feld 17 beispielsweise zwanzig Trennlinienabschnitte 18 nebeneinander erzeugt werden, sodass sich mit den acht Laserscannern 8 in einem Schritt 160 Trennlinienabschnitte 18 lasern lassen. Dabei kann eine hohe Bewegungsgeschwindigkeit des Laserfokuspunktes 29 (Figur 2) durch die Spiegel 12, 13 von beispielsweise 1200 mm/s erzielt werden. Die Beschleunigungszeit fällt sehr gering aus und kann deshalb vernachlässigt werden. Die Zustellung der Halterung 26 oder des Substrats 1 in Y-Richtung kann beispielsweise 0,5 Sekunden pro Schritt betragen, sodass bei einem 1,4 m²-Modul die Bearbeitungszeit für alle Trennlinien einer Schicht lediglich 27 Sekunden beträgt gegenüber z. B. ca. 90 Sekunden nach dem Stand der Technik.

Zudem kann ohne zusätzlichen konstruktiven Aufwand die Bewegungsgeschwindigkeit des Fokuspunktes 29 deutlich erhöht werden. Die Begrenzung der Bewegungsgeschwindigkeit des Fokuspunktes wird nur von der Güte des Laserprozesses begrenzt. Das heißt, die Bewegungsgeschwindigkeit kann statt 1200 mm/s auch beispielsweise 4000 m/s und mehr betragen, wodurch die Bearbeitungszeit auf 9 Sekunden oder weniger reduziert werden kann.

Wenn die Anlage gemäß Figur 3 und 4 als Durchlaufanlage konstruiert ist, kann zudem das Beladen des Substrats 1 an der einen Seite und das Entladen des Substrats 1 an der anderen Seite der Bearbeitungsstation 23 erfolgen, wobei die Fixierung des Substrats 1 in der vorgeschalteten Beladestation 21 bzw. das Freigeben des Substrats 1 in der Entladestation 24 durchgeführt werden kann, sodass als zusätzliche Zeit nur die Zeit für den Transport des Substrats 1 von der Beladestation 21 zu der Bearbeitungstation 23 sowie die Zeit zur Lageerkennung und Justierung des Substrats 1 in der Bearbeitungsstation 23 berücksichtigt zu werden braucht. Diese beiden Zeiten betragen jedoch nur ca. 5 Sekunden für den Transport und ca. 8 Sekunden für die Lageerkennung und Justierung, also nur etwa 13 Sekunden.

Durch eine exakte Kalibrierung in der Y- und X-Richtung in der Fokusebene der Laserscanner 8 und die durch Drift- und Offset-Kompensation der Galvanometer-Scanner-Technolgie kann das Überlappen der pro Feld 17 gelaserten Trennlinienabschnitte 18 im einstelligen µm-Bereich erfolgen.

Damit kann bei geringen apparativen Zusatzkosten die Bearbeitungszeit zur Bildung der Trennlinien 5, 6, 7 um mehr als 70 % verringert werden.

Vorstehend ist die Strukturierung in Y-Richtung erläutert, also bei dem rechteckigen Substrat 1 in Längsrichtung. Die Trennlinien und damit die Trennlinienabschnitte können sich jedoch auch in X-Richtung erstrecken, also z. B. über die gesamte Breite des beschichteten Substrats. Dazu werden in einem Schritt mit den Laserscannern 8 sich über die gesamte Breite, also Länge des Substrats 1 in X-Richtung erstreckende durchgehende Trennlinien gebildet. Dann erfolgt eine Relativbewegung der Laserscanner 8 und des Substrats 1 in Y-Richtung um höchstens einen Abstand, der der Länge L der Felder 17 entspricht, worauf mit den Laserscannern 8 erneut sich über die gesamte Breite der Funktionsschicht des Substrats 1 erstreckende durchgehenden Trennlinien gebildet werden, usw.

## Patentansprüche

1. Verfahren zur Bildung der Trennlinien (5, 6, 7), wobei die Trennlinien, die bei der Herstellung eines photovoltaischen Moduls mit serienverschalteten Zellen (C1, C2, ...) in der transparenten Frontelektrodenschicht (2), der Halbleiterschicht (3) und/oder der Rückelektrodenschicht (4), die als Funktionsschichten auf einem Substrat (1) abgeschieden sind, mit Laserscannern (8) mit einem drehbaren Spiegel (12, 13) erzeugt werden, wobei die Laserscanner (8) durch Ablenkung des Laserstrahls (14) mit dem drehbaren Spiegel (12, 13) nebeneinander angeordnete Trennlinienabschnitte (18) in nebeneinander angeordneten Feldern (17) in der oder den Funktionsschichten (2, 3, 4) erzeugen und die Laserscanner (8) und das beschichtete Substrat (1) entlang der zu bildenden Trennlinien (5, 6, 7) relativ zueinander bewegt werden, um weitere nebeneinander angeordnete Trennlinienabschnitte (18') in der oder den Funktionsschichten (2, 3, 4) zu erzeugen, sodass aus den Trennlinienabschnitten (18, 18') durchgehende Trennlinien (5, 6, 7) gebildet werden, **dadurch gekennzeichnet, dass** der Laserstrahl (14) nach Erzeugen eines Trennlinienabschnitts (18, 18') in dem jeweiligen Feld (17) mit dem Spiegel (12, 13) so ausgerichtet wird, dass er die nächste parallele Trennlinie (18, 18') in dem Feld (17) erzeugt und mehrere in Querrichtung (X) zu den Trennlinien (5, 6, 7) nebeneinander geordnete Laserscanner (8) verwendet werden, wobei die Breite (B) des Feldes (17), das von jedem Laserscanner (8) abgetastet wird, in Querrichtung (X) zu den Trennlinien (5, 6, 7) so bemessen ist, dass es von dem Feld (17), das von dem benachbarten Laserscanner (8) abgetastet wird, höchstens um einen Trennlinienabstand entfernt ist.

2. Verfahren nach Anspruch 1, **dadurch gekennzeichnet, dass** die Laserscanner (8) nach dem Abtasten des jeweiligen Feldes (17) relativ zu dem beschichteten Substrat (1) in Richtung (Y) der Trennlinien (5, 6, 7) um einen Abstand bewegt wird, der höchstens der Länge (L) des abgetasteten Feldes (17) in Richtung der Trennlinien (5, 6, 7) entspricht.

3. Verfahren nach Anspruch 1 oder 2, **dadurch gekennzeichnet, dass** der wenigstens eine Laserscanner (8) in einer Richtung (X) quer zur Richtung (Y) der Trennlinien (5, 6, 7) relativ zu dem beschichteten Substrat (1) um einen Abstand bewegt wird, der höchstens der Breite (B) des abgetasteten Feldes (17) entspricht, bis das beschichtete Substrat (1) über seine gesamte Breite mit den nebeneinander angeordneten Trennlinienabschnitten (18) versehen ist.

4. Verfahren nach einem der vorstehenden Ansprüche, **dadurch gekennzeichnet, dass** die Länge (L) bzw. Breite (B) des Feldes (17), das von jedem Laserscanner (8) in Richtung (Y) der Trennlinien bzw. Querrichtung (X) abgetastet wird, mindestens 100 mm beträgt.

5. Verfahren nach einem der vorstehenden Ansprüche, **dadurch gekennzeichnet, dass** der Laserstrahl (14) das beschichtete Substrat (1) mit einer Geschwindigkeit von mindestens 1 m/s abtastet.

6. Vorrichtung zur Durchführung des Verfahrens nach einem der vorstehenden Ansprüche, **dadurch gekennzeichnet, dass** die Laserscanner (8) jeweils wenigstens einen drehbaren Spiegel (12, 13) zur Ablenkung des Laserstrahls (14) aufweisen und eine Halterung (26) für die in Querrichtung (X) zu den Trennlinien (5, 6, 7) angeordneten Laserscanner (8), eine Aufnahme (22) für das beschichtete Substrat (1) und eine Einrichtung zur Relativbewegung der Halterung (26) und der Aufnahme (22) gegenüber einander in Richtung (Y) der zu bildenden Trennlinien (5, 6, 7) vorgesehen sind, ferner ein Antrieb zur Ansteuerung des wenigstens einen Spiegels (12, 13) der Laserscanner (8) derart, dass der Laserstrahl (14) in dem von ihm abgetasteten Feld (17) mehrere nebeneinander angeordnete Trennlinienabschnitte (18) in der oder den Funktionsschichten (5, 6, 7) erzeugt, wobei die Einrichtung zur Relativbewegung der Halterung (26) und der Aufnahme (22) derart ansteuerbar ist, dass die Laserscanner (8) und das beschichtete Substrat (1) zueinander um einen Abstand bewegt werden, der höchstens der Länge (L) des Feldes (17) in Richtung (Y) der Trennlinien (5, 6, 7) entspricht, um mit den miteinander fluchtenden Trennlinienabschnitten (18) durchgehende Trennlinien (5, 6, 7) zu bilden und die von zwei benachbarten Laserscannern (8) abgetasteten Felder (17) in Querrichtung (X) höchstens um einen Trennlinienabstand voneinander entfernt sind.

7. Vorrichtung nach Anspruch 6, **dadurch gekennzeichnet, dass** die nebeneinander angeordneten Laserscanner (8) an der Halterung (26) in Richtung (Y) der Trennlinien (5, 6, 7) derart versetzt angeordnet sind, dass ein in einer Richtung versetzter Laserscanner (8) auf Lücke zu zwei in der Gegenrichtung versetzten Laserscannern (8) ausgerichtet ist.

8. Vorrichtung nach einen der Ansprüche 6 oder 7, **dadurch gekennzeichnet, dass** die Halterung (26) durch ein in Richtung (Y) der Trennlinien verfahrbares Portal gebildet wird.

9. Vorrichtung nach einem der Ansprüche 6 bis 8, **dadurch gekennzeichnet, dass** die Aufnahme (22) für das beschichtete Substrat (1) in Richtung (Y) der Trennlinien t5, G, 7) und gegebenenfalls in Querrichtung (X) verfahrbar ausgebildet ist.

10. Vorrichtung nach einem der Ansprüche 6 bis 9, **dadurch gekennzeichnet, dass** eine Einrichtung vorgesehen ist, mit der der Laserstrahl (14) der Laserquelle (15) in Teilstrahlen geteilt wird, wobei in jedem Teilstrahl wenigstens ein Spiegel des Laserscanners (8) angeordnet ist.

11. Vorrichtung nach Anspruch 6, **dadurch gekennzeichnet dass** der Antrieb dies wenigstens einen Spiegels (12, 13) durch einen Galvanometerantrieb gebildet wird.

12. Vorrichtung nach einem der Ansprüche 6 bis 11, **dadurch gekennzeichnet, dass** der Laserscanner (8) zwei im Winkel zueinander angeordnete drehbare Spiegel (12, 13) aufweist, über die der Laserstrahl (14) auf das beschichtetete Substrat (1) reflektiert wird.

13. Vorrichtung nach einem der Ansprüche 6 bis 12, **gekennzeichnet durch** eine Einrichtung zum Transport des von der Aufnahme (22) aufgenommenen beschichteten Substrats (1) von einer Beladestation (21) auf der einen Seite der Laserstrukturierungsvorrichtung, der die Bearbeitungsstation (23) der Anlage bildet, zu einer Entladestation (24) auf der anderen Seite der Bearbeitungsstation (23).

14. Vorrichtung nach Anspruch 13, **dadurch gekennzeichnet, dass** ein Mehrachsenroboter zur Beladung der Beladestation (21) mit dem beschichteten Substrat (1) vorgesehen ist.

15. Vorrichtung nach einem der Ansprüche 6 bis 14, **dadurch gekennzeichnet, dass** die Aufnahme (22) eine Fixiereinrichtung für das beschichtete Substrat (1) aufweist.

16. Vorrichtung nach einem der Ansprüche 6 bis 15, **gekennzeichnet durch** eine Einrichtung zur Lageerkennung und Justierung des von der Aufnahme (22) aufgenommenen Substrats (1).

17. Vorrichtung nach einem der Ansprüche 6 bis 16, **dadurch gekennzeichnet, dass** der Laser (15) des Laserscanners (8) durch einen Neodym dotierten Yttrilum-Aluminium-Granat- oder Yttrium-Vanadat-Festkörperlaser gebildet ist.
